# EUROPEAN PATENT APPLICATION

(11) **EP 0 676 795 A1**
(43) Date of publication of application: **11.10.1995**
(21) Application number: 95105406.3
(22) Date of filing: 10.04.1995
(51) Int. Cl.: H01L 21/20

(54) **Method for selectively growing semiconductor substrate**

(30) Priority: 11.04.1994 JP 71712/94; 27.06.1994 JP 144276/94
(71) Applicant: NEC CORPORATION, Tokyo (JP)
(72) Inventor: Matsumoto, Takashi, c/o NEC Corporation, Tokyo (JP)
(74) Representative: Baronetzky, Klaus, Dipl.-Ing.

(57) **Abstract**

In a method for selectively growing a semiconductor substrate, a substrate is selectively grown by a MOVPE (Metal Organic Phase Epitaxial Growth) method using DMA1H as aluminum material. A semiconductor substrate is selectively grown by a MOVPE (Metal Organic Phase Epitaxial Growth) method using TMA (Tri-Methyl-Aluminum) as aluminum material and carrier gas of selected from nitrogen and inert gas.

## Description

### FIELD OF THE INVENTION

The invention relates to a method for selectively growing a semiconductor substrate, especially to an improved method for crystal-growing a compound semiconductor substrate.

### BACKGROUND OF THE INVENTION

Recently, Sasaki et al. have described a selective growing method of InGaAsP system using an MOVPE (Metal Organic Vapor Phase Epitaxy) method on pages 435 in Journal of Crystal Growth, Vol. 132, 1993. According to the description, it is clear that the selectivity and the crystal compound on growth regions change depending on the width of a mask. Now, devices made by a selective growth method is used. In a system including Al, Kamon et al. have described a method for growing an AlGaAs substrate using TMA on page L10, Japanese Journal of Applied Physics, No. 1, Vol. 25, 1986. In this method, growth processing is carried out at 10 Torr of growth pressure, which is lower than 76 to 100 Torr of ordinal methods. This method can not perform growth at the ordinal growth pressure, because Al (Aluminum) reacts to a mask material such as of SiO₂ and SiO_{X} thereby the Al can not be re-evaporated. Therefore, a new type of growth apparatus is required.

For growth processing at ordinal growth pressure 76 to 100 Torr, an AlGaAs substrate is selectively grown by adding Hcl gas to the substrate, shown on page 235, Journal of Crystal Growth 124, 1992 by Shimoyama et al. According to the selective growth of Shimoyama et al., there are some problems in that Hcl gas has low purity, and has strong corrosion characteristics; and therefore, the method can not be applied to substrates needing high purity such as active layer of semiconductor laser. The composition of III group of material is changed in a selective growth region in response to change of the concentration of Hcl gas. Especially in selective embedded growth, gas concentration may be changed in a depressed portion for embedded growth because of diffusion of hydrogen chloride and aluminum chloride depending on the shape of depressed portion.

Shima et al. reported a method for selective embedded growth using a lattice match system of AlGaAs shown on page 1059, Vo. 3, 54th meeting of applied physics. According to the method, however, fabricated devices by the method do not work well because of misfit stress.

T. F. Keuch et al. have described a method for selectively growing an AlGaAs substrate by using metal organic material including halogen such as DEGaCl and DMAlCl on page 116, Journal of Crystal Growth 107, 1991. This selective growth can be realized because aluminum formed on an SiO₂ or SiO_{X} mask is re-evaporated by AlCl_{X} compound.

### SUMMARY OF THE INVENTION

Accordingly, an object of the invention is to provide an improved method for selective growth whereby a compound semiconductor crystal substrate including aluminum can be selectively grown without HCl gas in ordinal condition of MOVPE growth.

Another object of the invention is to provide an improved method for selective embedded growth whereby a compound semiconductor crystal substrate including aluminum can be selectively embedded grown with small change of III group compound.

According to an aspect of the invention, in a method for selectively growing a semiconductor substrate, a substrate is selectively grown by a MOVPE (Metal Organic Phase Epitaxial Growth) method using DMAlH as aluminum material. In more detail, the method includes the steps of: providing a compound semiconductor substrate; providing a growth region on the compound semiconductor substrate; and selectively growing the compound semiconductor substrate by a MOVPE (Metal Organic Phase Epitaxial Growth) method using DMAlH as aluminum material. This aspect is applicable to selective embedded growth, as well.

As Nizawa et al. described in Japanese Patent Publication Kokai H2-185026, DMAlH having a high vapor pressure is used for selective growth of Al as conductive lines of Si electric devices. When DMAlH is heated at 200 to 300°C, no Al is accumulated on an SiO₂ or SiN_{X} mask. The material DMAlH has never heated at 600 to 800°C to be used for selective epitaxial growth of III-V group of compound semiconductor. DMAlH has large amount of connection energy. As shown on page 319, in a material for 40th applied physics meeting, by Hiraoka et al., DMAlH needs 30 Kcal/mol energy to resolve dimer into monomers, which is much larger than 4 Kcal/mol for TMA usually used as Al material in MOVPE growth. DMAlH is not resolved like as "(DMAlH)₂ → DMAlH → Al" in the phase, and therefore that is supplied on the surface of the substrate whereby surface reaction occurs directly. Because every Al material is coupled to H material or C material in the DMAlH dimer supplied onto an SiO₂ or SiN_{X}, Al and the mask material are not coupled to each other directly. The DMAlH on the mask has less absorption energy as compared to other Al material, whereby the DMAlH can be re-vaporized easily. Therefore, selective epitaxial growth can be realized under ordinal condition. The DMAlH selective growth is not affected by change of concentration of HCl because no HCl is used in the growth treatment. Especially, in selective embedded growth, embedded region has consistent III group composition relative to the growth using HCl system; and therefore, improved embedded growth can be realized without composition distortion.

According to another aspect of the invention, in a method for selectively growing a semiconductor substrate, a semiconductor substrate is selectively grown by a MOVPE (Metal Organic Phase Epitaxial Growth) method using TMA (Tri-Methyl-Aluminum) as aluminum material and carrier gas of selected from nitrogen and inert gas. In more detail, the method includes the steps of: providing a compound semiconductor substrate; providing a growth region on the compound semiconductor substrate; and selectively growing the compound semiconductor substrate by a MOVPE (Metal Organic Phase Epitaxial Growth) method using TMA (Tri-Methyl-Aluminum) as aluminum material and carrier gas of selected from nitrogen and inert gas. This aspect is applicable to selective embedded growth.

Generally in MOVPE growth, hydrogen is used as carrier gas, however, if TMA is heated in hydrogen carrier gas atmosphere, hydrogenation occurs therein. On the other hand, if TMA is heated in nitrogen or inert gas, simple pyrolysis occurs. In this kind of pyrolysis, there is 66 Kcal/mol of Al-C dissociation energy which is larger than that of hydrogenation. Thus, a constant of decomposition speed of TMA is small at a predetermined growth temperature. In a gaseous phase with carrier gas of nitrogen or inert gas, TMA is supplied to the surface of substrate without a phase decomposition of: TMAl → DMA → MMA → Al, and surface decomposition is reacted directly thereon. Because every Al material is coupled to C material in the TMA supplied onto an SiO₂ or SiN_{X}, Al and the mask material are not coupled to each other directly. The TMA on the mask has less absorption energy as compared to DMA, MMA and Al material, whereby the TMA can be re-vaporized easily. Therefore, selective epitaxial growth can be realized under ordinal condition. The selective growth is not affected by change of concentration of HCl because no HCl is used in the growth treatment. Especially, in selective embedded growth, embedded region has consistent III group composition relative to the growth using HCl system; and therefore, improved embedded growth can be realized without composition distortion.

### BRIEF DESCRIPTION OF THE DRAWINGS

Fig. 1 is a cross-sectional view showing a semiconductor substrate fabricated by a method of a first preferred embodiment according to the invention.

Fig. 2 is a cross-sectional view showing a semiconductor substrate fabricated by a method of a second preferred embodiment according to the invention.

### DESCRIPTION OF THE PREFERRED EMBODIMENTS

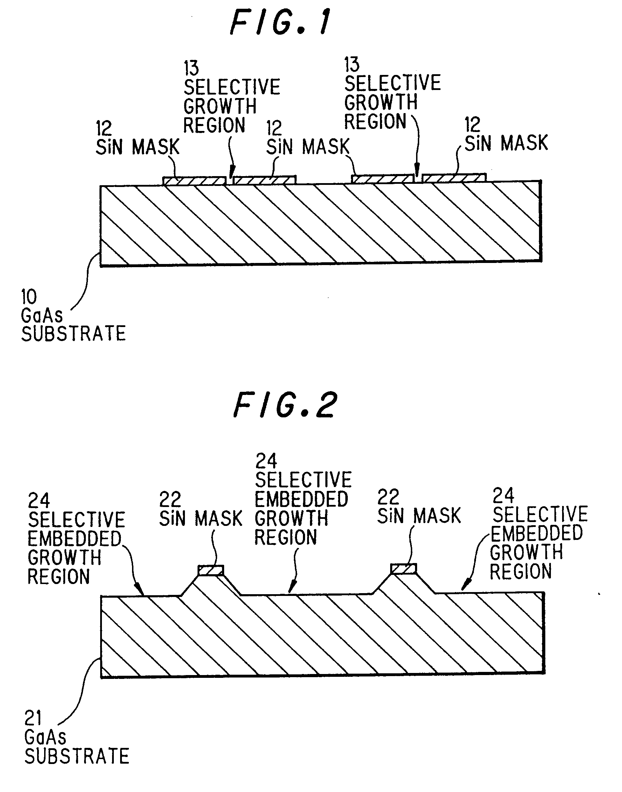

Fig. 1 shows a first preferred embodiment according to the invention, which includes a GaAs substrate 10, a GaAlAs growth region 13 and an SiN_{X} stripe mask 12. The GaAlAs growth region 13 and SiN_{X} mask 12 are formed by general photo-lithography technology to have width of 2µm and 10µm, respectively. The substrate is selectively grown by a horizontal reduced pressure type of MOVPE apparatus at a substrate temperature of 700°C, and a growth pressure of 76 Torr. The growth is carried out using hydrogen as carrier gas, 10cc/min of AsH₃ as V group material and 0.3cc/min of DMAlH and TMG as III group material. On the other hand, reference crystal is fabricated by adding TMA and TMG as III group material instead of DMAlH and TMG.

In analysis, when these two fabricated crystals are observed by an SEM, the inventive crystal has no deposit on the mask 12; and in contrast, the reference crystal has many deposits, which can be considered as polycrystalline, on the mask 12. In SIMS analysis, it is Al_{0.5}Ga_{0.5}As.

In the first preferred embodiment, the growth may be carried out using 20 l/min of nitrogen as carrier gas, 10cc/min of AsH₃ as V group material and 0.3cc/min of TMA and TMG as III group material. On the other hand, reference crystal is fabricated by using hydrogen as carrier gas.

In analysis, when these two fabricated crystals are observed by an SEM, the inventive crystal has no deposit on the mask 12; and in contrast, the reference crystal has many deposits, which can be considered as polycrystalline, on the mask 12. In SIMS analysis, it is Al_{0.5}Ga_{0.5}As.

Fig. 2 shows a second preferred embodiment according to the invention, which includes a GaAs substrate 21, an embedded growth region 24 and an SiN_{X} stripe mask 22. The GaAlAs growth region 13 and SiN_{X} mask 12 are formed by general photolithography technology to have width of 20µm and 2µm, respectively, then the substrate is etched by about 2µm using solution of sulfuric and hydrogen peroxide to form an AlInP selective embedded growth substrate. The substrate is selectively grown by a horizontal reduced pressure type of MOVPE apparatus at a substrate temperature of 700°C, and a growth pressure of 76 Torr. The growth is carried out using hydrogen as carrier gas, 60cc/min of PH₃ as V group material and 0.3cc/min of DMAlH and TMIn as III group material. On the other hand, reference substrate is fabricated by hydrogen chloride system of selective growth adding 0.3cc/min of TMA and TMIn and 0.1cc/min of HCl.

In analysis, when these two fabricated crystals are observed by an SEM, either the inventive crystal and the reference crystal has no deposit on the mask 22. In SIMS analysis for average composition on the growth region 24, however, the inventive crystal includes Al_{0.5}In_{0.5}P. In contrast, the reference crystal includes to much In whereby large lattice mis-matching with the GaAs substrate is found. In analysis of composition on the growth region 24, the inventive substrate has consistent composition and flat shape. On the other hand, the reference substrate has composition change between the center and the side surface of mesa shape including much Al composition.

The inventive method brings the same effect to selective embedded growth of a crystal of (Al_{1-X}Ga_{X})_{0.5}In_{0.5}P(0<X<0.5), which is made by adding Ga to AlInP crystal. Also, the inventive method is applicable to selective embedded growth on an InP substrate of AlInAs crystal, in which V group material of AlInP crystal is replaced by As.

In the second preferred embodiment, the growth may be carried out using nitrogen as carrier gas, 60cc/min of PH₃ as V group material and 0.3cc/min of TMA and TMIn as III group material. On the other hand, reference crystal is fabricated by using hydrogen as carrier gas, supplying 0.1cc/min of HCl and selectively grown in hydrogen chloride system.

In analysis, when these two fabricated crystals are observed by an SEM, each crystal has no deposit on the mask 22. In SIMS analysis for average composition on the growth region 24, however, the inventive crystal includes Al_{0.5}In_{0.5}P. In contrast, the reference crystal includes to much In whereby large lattice mis-matching with the GaAs substrate is found. In analysis of composition on the growth region 24, the inventive substrate has consistent composition and flat shape. On the other hand, the reference substrate has composition change between the center and the side surface of mesa shape including much Al composition.

The inventive method brings the same effect to selective embedded growth of a crystal of (Al_{1-X}Ga_{X})_{0.5}In_{0.5}P(0<X<0.5), which is made by adding Ga to AlInP crystal. Also, the inventive method is applicable to selective embedded growth.

Although the invention has been described with respect to specific embodiments for complete and clear disclosure, the appended claims are not to be thus limited but are to be construed as embodying all modification and alternative constructions that may occur to one skilled in the art which fairly fall within the basic teaching herein set forth.

## Claims

1. A method for selectively growing a semiconductor substrate, comprising the steps of:
providing a compound semiconductor substrate;
providing a growth region on the compound semiconductor substrate; and
selectively growing the compound semiconductor substrate by a MOVPE (Metal Organic Phase Epitaxial Growth) method using DMAlH as aluminum material.

2. The method according to claim 1, wherein:
said selective growing step is selective embedded growing step.

3. The method according to claim 1, wherein:
said compound semiconductor substrate is of GaAs; and
said growth region is of GaAlAs defined by a mask of SiN.

4. The method according to claim 1, wherein:
said compound semiconductor substrate is of GaAs;
said growth region is of AlInP defined by a mask of SiN, the growth region is formed by etching the compound semiconductor substrate with combined solution of sulfuric and hydrogen peroxide; and
said selective growing step is selective embedded growing step.

5. The method according to claim 1, wherein:
said selective growing step is carried out by a horizontal type of reduced pressure MOVPE apparatus using hydrogen as carrier gas.

6. A method for selectively growing a semiconductor substrate, comprising the steps of:
providing a compound semiconductor substrate;
providing a growth region on the compound semiconductor substrate; and
selectively growing the compound semiconductor substrate by a MOVPE (Metal Organic Phase Epitaxial Growth) method using TMA (Tri-Methyl-Aluminum) as aluminum material and carrier gas of selected from nitrogen and inert gas.

7. The method according to claim 6, wherein:
said selective growing step is selective embedded growing step.

8. The method according to claim 6, wherein:
said compound semiconductor substrate is of GaAs; and
said growth region is of GaAlAs defined by a mask of SiN.

9. The method according to claim 6, wherein:
said compound semiconductor substrate is of GaAs;
said growth region is of AlInP defined by a mask of SiN, the growth region is formed by etching the compound semiconductor substrate with combined solution of sulfuric and hydrogen peroxide; and
said selective growing step is selective embedded growing step.

10. The method according to claim 6, wherein:
said selective growing step is carried out by a horizontal type of reduced pressure MOVPE apparatus using hydrogen as carrier gas.
